# FASCICULE DE BREVET EUROPEEN

(11) **EP 2 399 864 B1**
(45) Date de publication et mention de la délivrance du brevet: **30.03.2016**
(21) Numéro de dépôt: 11170671.9
(22) Date de dépôt: 21.06.2011
(51) Int. Cl.: B81C 1/00, H01L 21/603, B23K 20/02, H01L 23/10, H01L 21/50

(54) **Procédé de scellement de deux éléments par thermocompression a basse température**
Versiegelungsverfahren von zwei Elementen durch Thermokompression bei niedriger Temperatur
Method for sealing two elements by low-temperature thermocompression

(30) Priorité: 23.06.2010 FR 1055014
(43) Date de publication de la demande: 28.12.2011
(73) Titulaire: Commissariat à l'Énergie Atomique et aux Énergies Alternatives, 75015 Paris (FR)
(72) Inventeur: Garnier, Arnaud, 38000 GRENOBLE (FR)
(74) Mandataire: Ilgart, Jean-Christophe

(56) Documents cités:
- DE-A1- 10 309 677
- DE-A1- 19 619 921
- US-A- 4 077 558
- US-A1- 2006 170 089

## Description

### DOMAINE TECHNIQUE

L'invention concerne le domaine de l'assemblage de deux éléments. L'invention concerne notamment le scellement entre deux substrats par l'intermédiaire de matériaux de scellement. L'invention est également bien adaptée pour réaliser un scellement hermétique lors d'un packaging de microsystèmes tels que des dispositifs MEMS et/ou NEMS, ou lors de la réalisation d'interconnexions 3D.

### ÉTAT DE LA TECHNIQUE ANTÉRIEURE

Plusieurs techniques existent pour réaliser un scellement entre deux substrats, par exemple lors d'un packaging d'un dispositif microélectronique tel qu'un MEMS, afin de garantir l'herméticité d'une cavité formée entre ces deux substrats dans laquelle le dispositif est destiné à être encapsulé.

Il est par exemple possible de réaliser un scellement moléculaire par collage direct des deux substrats. Dans ce cas, les surfaces à coller doivent être planes et peu rugueuses (par exemple : rugosité RMS < 0,5 nm en AFM (microscopie à force atomique) 5x5µm²), nécessitant donc la mise en oeuvre d'étapes de préparation de surface spécifiques. Ce type de scellement est également très sensible à la contamination particulaire, ce qui le rend difficile à mettre en oeuvre pour le packaging de microsystèmes comportant des structures libérées ne supportant pas de nettoyage en chimie liquide.

Il est également possible de réaliser un scellement anodique entre les deux substrats. Ce type de scellement est généralement limité à l'assemblage d'un substrat de verre avec un substrat de silicium. Il requiert l'application d'une tension de l'ordre de quelques centaines de volts entre les substrats, ce qui est incompatible avec de nombreuses applications microélectroniques.

Il est également possible de réaliser un scellement métallique eutectique ou un scellement par TLP (« Transient Liquid Phase » en anglais) entre les deux substrats. Dans le cas d'un scellement métallique eutectique, chaque substrat est revêtu d'une sous-couche destinée à être solidarisée à la sous-couche de l'autre substrat par l'intermédiaire d'une brasure métallique. Un traitement thermique à une température supérieure à la température de fusion de l'alliage métallique destiné à former la brasure fait passer cet alliage en phase liquide. Cette phase liquide doit bien mouiller les sous-couches sur lesquelles elle est initialement positionnée. Dans le cas d'un scellement par TLP, la composition de l'alliage de la brasure évolue lors du passage par la phase liquide (par diffusion solide-liquide) et la température de fusion du matériau évolue alors que la température de procédé peut rester constante. Il y a alors solidification isotherme. Dans les deux cas (scellement métallique eutectique et scellement TLP), le passage nécessaire par une phase liquide de la brasure présente plusieurs inconvénients :
- il limite la stabilité dimensionnelle de l'empilement, et notamment l'espacement entre les substrats,
- il peut engendrer des trous dans l'alliage après scellement (par exemple dans le cas d'une solidification isotherme très rapide (retassures) et en présence de butées),
- il favorise la désorption des impuretés durant le passage en phase liquide, ce qui peut dégrader le vide dans la cavité,
- il peut créer des courts-circuits par coulure de l'alliage si des connexions métalliques se trouvent à proximité.

Le scellement peut également être réalisé par thermocompression. Dans ce cas, les surfaces à coller doivent être exemptes d'oxyde et relativement peu rugueuses, et les matériaux sous-jacents assez ductiles à la température de scellement choisie. Ce type de scellement, qu'il soit de type puce sur plaque ou plaque sur plaque de type Au/Au, Cu/Cu ou Al/Al, présente plusieurs contraintes :
- les bilans thermiques à appliquer sont relativement élevés, et par exemple compris entre 260°C et 450°C pendant une durée comprise entre 1 mn et 90 mn pour de l'or, ou compris entre 300°C et 400°C pendant une durée de 30 mn pour du cuivre, ou encore égal à 450°C pour de l'aluminium,
- les pressions réelles appliquées sur les surfaces à coller sont relativement élevées, c'est-à-dire comprises entre 0,4 MPa et une centaine de MPa, sachant que plus la rugosité des surfaces à coller est grande, plus la pression à appliquer l'est également,

- il est nécessaire que les rugosités des surfaces à sceller soient relativement faibles, par exemple inférieures à 3 nm mesurées en scan AFM 5x5µm²,
- une préparation de surface adaptée doit être réalisée pour nettoyer et/ou désoxyder les surfaces à sceller : dans le cas d'un scellement or/or, les surfaces peuvent être nettoyées pour la contamination organique en UV-ozone pendant 90 mn, ou en H₂O:H₂O₂:NH₄OH (60:12:1) à une température de 70°C pendant 10 mn ou encore en H₂SO₄:H₂O₂ (1:1) pendant 1 mn ; dans le cas d'un scellement cuivre/cuivre, les surfaces sont désoxydées avec du HCl ; dans le cas de l'aluminium, l'affinité de l'aluminium avec l'oxygène de l'air impose une désoxydation avant scellement, ainsi qu'un enchaînement très contraignant désoxydation - scellement.

Le document US 2006/170089 A1 décrit la réalisation d'un scellement par thermocompression.

On voit donc que chaque méthode de scellement présente des inconvénients.

Certains microsystèmes nécessitent un packaging hermétique qu'il est préférable de réaliser par scellement métallique pour les raisons suivantes :
- meilleure herméticité théorique,
- possibilité de communication électrique entre les substrats à coller,
- pas besoin d'appliquer de fortes tensions pouvant détériorer les dispositifs à encapsuler, contrairement à un scellement anodique,
- pas d'utilisation systématique de capot en verre, contrairement à un scellement anodique,
- pas de fortes contraintes sur la rugosité et la contamination particulaire de la surface, contrairement à un collage moléculaire.

Toutefois, il est parfois préférable d'éviter de réaliser un scellement métallique en raison du passage en phase liquide de la brasure pour les raisons suivantes :
- espace entre les substrats à sceller (sans ajouter des butées qui complexifient la technologie) difficile à maîtriser,
- le passage en phase liquide est susceptible d'engendrer la désorption de gaz emprisonnés dans le métal ou l'alliage métallique (notamment après un dépôt électrolytique où du H₂ est notamment retrouvé dans les matériaux déposés),
- difficulté de maîtrise des compositions chimiques des alliages et des températures de scellement sur l'ensemble des surfaces à coller (particulièrement en plaques de diamètre 200 mm) ; dans ce cas, il est nécessaire d'augmenter la température de scellement pour s'assurer que l'alliage est bien passé en phase liquide, ce qui n'est pas souhaitable si le bilan thermique des dispositifs à assembler est limité et proche du bilan thermique de scellement,
- difficile d'éviter les courts-circuits potentiels avec les éléments de la puce.

### EXPOSÉ DE L'INVENTION

Un but de la présente invention est de proposer un nouveau procédé de scellement ne présentant pas les inconvénients des procédés de scellement de l'art antérieur.

Pour cela, la présente invention propose un procédé de scellement entre au moins deux éléments, comportant au moins les étapes de :
- réalisation d'au moins un premier matériau de scellement sur au moins une face d'un premier desdits deux éléments,
- réalisation d'au moins un second matériau de scellement, différent du premier matériau de scellement, sur au moins une face d'un second desdits deux éléments,
- solidarisation desdits deux éléments par thermocompression des matériaux de scellement l'un contre l'autre à une température Tc inférieure aux températures de fusion des premier et second matériaux de scellement,
dans lequel les premier et second matériaux de scellement sont choisis tels qu'ils comportent chacun au moins une phase apte à réagir avec la phase de l'autre matériau de scellement par interdiffusion des constituants des phases des matériaux de scellement lors de l'étape de solidarisation.

Lors de l'étape de solidarisation, les phases des matériaux de scellement réagissent ensemble en formant au moins une autre phase solide dont la température de fusion est supérieure à la température Tc.

Le procédé de scellement selon l'invention propose de réaliser une thermocompression de deux matériaux de scellement à une température inférieure aux températures de fusion de ces matériaux de scellement, ce qui représente un faible bilan thermique par rapport aux procédés de scellement de l'art antérieur. Ainsi, le premier matériau de scellement et/ou le second matériau de scellement ne passe pas en phase liquide mais ramolli, c'est-à-dire devient relativement plus mou, ce qui permet de mettre en oeuvre la thermocompression à des pressions relativement faibles sans se préoccuper des éventuelles rugosités au niveau des surfaces des matériaux de scellement, ni qu'il y est besoin de réaliser un nettoyage ou une désoxydation des surfaces à sceller. Etant donné que la rugosité des matériaux de scellement n'a pas d'importance ici, le procédé de scellement selon l'invention ne nécessite pas la mise en oeuvre d'étape supplémentaire de planarisation des matériaux de scellement.

Lors de la mise en oeuvre de ce procédé de scellement, le ramollissement d'au moins un des matériaux de scellement à une température de scellement par exemple proche de la température de fusion permet, grâce à la pression mécanique appliquée entre les deux éléments, de déformer le ou les matériaux de scellement ramollis, pour assurer au final un bon contact entre les deux surfaces à coller, favorisant la réaction par interdiffusion entre les deux matériaux de scellement permettant l'adhésion entre les deux éléments.

De plus, aucun traitement chimique de surface n'est requis pour retirer une éventuelle fine couche d'oxyde qui se serait formée en surface des matériaux de scellement, cette éventuelle fine couche d'oxyde pouvant être conservée. Une telle couche d'oxyde, par exemple à base d'étain, peut apparaitre par exemple en surface d'un premier matériau de scellement formé par les phases Au₅Sn et AuSn. La solidarisation de ce premier matériau de scellement est compatible avec une couche d'or, formant le second matériau de scellement, qui ne s'oxyde pas. De plus, étant donné que les matériaux de scellement ne passent pas en phase liquide, la thermocompression n'induit pas de coulure, ce qui évite les risques de court-circuit, et l'espacement entre les éléments scellés est maîtrisé. Enfin, le scellement ainsi réalisé offre une très bonne tenue mécanique des éléments scellés.

L'herméticité obtenue avec ce nouveau procédé de scellement est également très bonne. Par exemple, dans le cas d'un substrat comportant une membrane formant le capot d'une cavité solidarisé à un autre substrat par le procédé selon l'invention, des mesures de déflexion de la membrane sous atmosphère contrôlée ont permis d'observer aucune déflexion de la membrane dans le temps. Cette herméticité vient notamment du fait que la phase de scellement formée comporte très peu de pores après la mise en oeuvre du procédé de scellement.

Le terme « phase » désigne un alliage, ou un corps pur, chimiquement et physiquement homogène, c'est-à-dire dans lequel les paramètres physiques et chimiques varient de manière continue, c'est-à-dire linéairement.

Les matériaux de scellement peuvent être des matériaux métalliques purs, par exemple de l'or, de l'étain, du cuivre, de l'aluminium, etc. Dans une variante, les matériaux de scellement peuvent être des alliages métalliques homogènes ou non, par exemple de l'AuSn, de l'Au₅Sn, de l'AuIn, etc. On entend par « alliage homogène » un alliage présentant une seule phase, et par « alliage non homogène » un alliage présentant plusieurs phases mélangées ou superposées (par exemple AuSn + Au₅Sn). Il est également possible qu'un des matériaux de scellement soit un métal pur et que l'autre des matériaux de scellement soit un alliage.

Lors de l'étape de solidarisation, les phases des matériaux de scellement réagissent ensemble en formant au moins une autre phase. Cette autre phase est solide et a une température de fusion qui est supérieure à la température Tc. Ainsi, lors de la thermocompression, aucune des phases présentes entre les deux éléments à sceller ne se trouve à l'état liquide, ce qui permet d'éviter d'avoir à réaliser un nettoyage ou une désoxydation des surfaces à sceller ainsi que les risques de court-circuit liés à des coulures des phases en présence.

La température Tc peut être inférieure à environ 300°C.

Le premier et/ou le second matériau de scellement est un alliage eutectique.

Selon l'invention, la réalisation d'un matériau de scellement qui est un alliage eutectique est obtenue au moins par la mise en oeuvre de plusieurs dépôts successifs de matériaux destinés à former l'alliage eutectique, et d'au moins un traitement thermique desdits matériaux destinés à former l'alliage eutectique à une température inférieure aux températures de fusion respectives desdits matériaux destinés à former l'alliage eutectique, homogénéisant lesdits matériaux.

Le premier matériau de scellement peut être un alliage à base d'or et d'étain, le second matériau de scellement pouvant être de l'or. Le choix de tels matériaux de scellement est intéressant pour les raisons suivantes :
- le bilan thermique de scellement est relativement faible, par exemple environ 270°C pendant environ 20 mn,
- la pression réelle à appliquer sur les surfaces à coller est relativement faible, par exemple égale à environ 5 MPa,
- aucune précaution particulière n'est à prendre concernant une éventuelle rugosité des surfaces à sceller,
- il n'est pas nécessaire de réaliser une désoxydation ou un nettoyage des surfaces à sceller.

L'étape de solidarisation peut être mise en oeuvre à une température supérieure à environ 200°C ou 230°C, et/ou peut comporter une compression du premier matériau de scellement contre le second matériau de scellement à une pression supérieure environ 10⁶ Pa (correspondant à la pression obtenue sur la surface effectivement collée). Cette température pourra être choisie la plus haute possible, tout en restant compatible avec la technologie et l'application mises en oeuvre, afin de favoriser l'interdiffusion des constituants de chaque matériau de scellement, minimisant ainsi le temps de scellement étant donné que les matériaux de scellement, ou l'un des matériaux de scellement, deviennent rapidement malléables.

L'épaisseur du premier et/ou du second matériau de scellement réalisé peut être comprise entre environ 100 nm et quelques dizaines de micromètres, par exemple comprise entre environ 100 nm et 50 µm. Des épaisseurs plus importantes peuvent également être envisagées en fonction des contraintes d'encombrement à respecter.

Au cours de la réalisation du premier matériau de scellement et/ou du second matériau de scellement, une ou plusieurs phases, différentes de la ou des phases du premier et/ou du second matériau de scellement, peuvent se former sur la face du premier et/ou du second élément, le premier et/ou le second matériau de scellement étant alors disposés sur ladite ou lesdites phases. Ce cas sera particulièrement avantageux lorsque les matériaux de scellement sont de l'or et de l'AuSn. Ainsi, l'AuSn est stabilisé par un traitement thermique (TTH) afin d'éviter l'évolution de l'alliage dans le temps (interdiffusion Au/Sn à température ambiante) et former les phases proches de l'équilibre thermodynamique permettant le scellement, et éviter l'oxydation de l'étain. De plus, cette ou ces phases intermédiaires peuvent également servir à absorber les déformations induites lors de cycles de température pendant les étapes mises en oeuvre avant le scellement.

Le premier matériau de scellement peut avoir une dureté différente de la dureté du second matériau de scellement. Une différence de dureté entre les deux matériaux de scellement permet de réaliser, lors de la thermocompression, une déformation du matériau de scellement le moins dur, permettant au matériau de scellement le moins dur d'épouser la forme du matériau de scellement le plus dur.

Le premier et/ou le second matériau de scellement peut avoir une température de fusion inférieure à environ 400°C.

L'étape de solidarisation peut être mise en oeuvre sous vide, permettant ainsi d'éviter de piéger des gaz, par exemple dans les matériaux de scellement, lors du procédé de scellement.

Chaque élément peut comporter un substrat, ou support. Le procédé selon l'invention est notamment applicable à toutes sortes de substrats nécessitant d'être assemblés par un lien métallique, ce dernier pouvant définir des cavités comme dans le cas particulier du packaging de MEMS (à l'échelle d'une plaquette entière (wafer) sur laquelle plusieurs puces électroniques sont réalisées ou à l'échelle d'une puce électronique). Ce sera le cas lorsque l'on réalise une encapsulation d'un ou plusieurs microcomposants, l'un des deux substrats comportant le ou les microcomposants au niveau de la face destinée à recevoir l'un des matériaux de scellement, et l'autre des deux substrats servant de capot à ce ou ces microcomposants.

Les matériaux de scellement peuvent être réalisés, sur les éléments, sous forme de couches ou de cordons, ou encore être réalisés selon n'importe quel motif. La réalisation des matériaux de scellement sous forme de cordons peut notamment servir lors d'une encapsulation de microcomposant(s), les cordons de matériaux de scellement étant réalisés en périphérie de la ou des cavités d'encapsulation.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1C représentent schématiquement les étapes d'un procédé de scellement, objet de la présente invention, selon un mode de réalisation particulier,
- les figures 2A à 2D représentent les étapes d'un procédé de scellement, objet de la présente invention, selon un autre mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

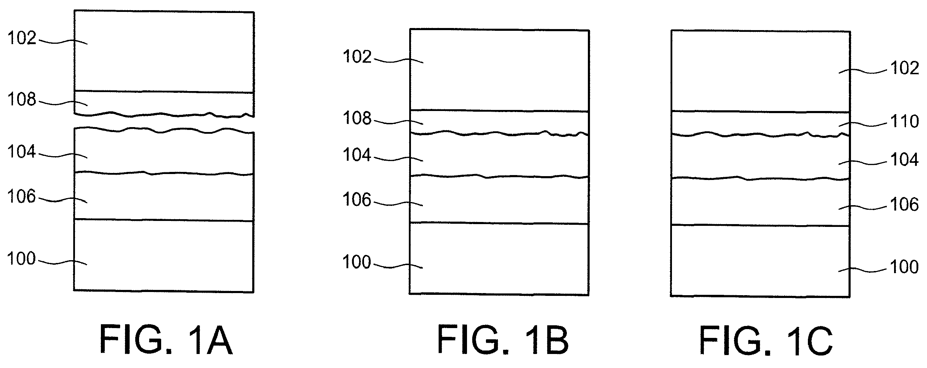

On se réfère tout d'abord aux figures 1A à 1C qui représentent schématiquement les étapes d'un procédé de scellement de deux substrats 100 et 102 selon un mode de réalisation particulier.

Comme représenté sur la figure 1A, on réalise une couche 104 d'un premier matériau de scellement sur une face du premier substrat 100. Bien qu'il soit possible de réaliser la couche 104 directement contre le premier substrat 100, il est également possible, comme c'est le cas sur la figure 1A, que la réalisation de la couche 104 conduise à la formation d'une ou plusieurs autres phases 106 sur le premier substrat 100.

Une couche 108 d'un second matériau de scellement est réalisée sur une face du second substrat 102. Le second matériau de scellement est de nature différente du premier matériau de scellement. Ces deux matériaux de scellement sont choisis tels que les constituants de la ou des phases de ces matériaux soient susceptibles de réagir ensemble pour former au moins une autre phase.

Comme représenté sur la figure 1B, on met ensuite en contact et en pression la couche 104 contre la couche 108. Cet assemblage est réalisé à une température Tc inférieure aux températures de fusion des matériaux de scellement formant les couches 104 et 108, et par exemple inférieure à environ 300°C. On réalise ainsi une thermocompression particulière au cours de laquelle a lieu une interdiffusion des constituants des matériaux de scellement des couches 104 et 108. Cette interdiffusion forme une ou plusieurs autres phases 110 qui scellent ainsi les substrats 100 et 102 l'un avec l'autre (figure 1C). En fonction des épaisseurs initiales des couches de matériaux de scellement 104 et 108, la ou les phase 110 peuvent être formées par la totalité des constituants des deux couches 104 et 108, ou par la totalité des constituants d'une des couches 104 ou 108 et une partie des constituants de l'autre des couches, respectivement 108 ou 104, ou encore une partie des constituants des deux couches 104 et 108.

La température Tc à laquelle est réalisée la thermocompression est ici choisie proche de la température de fusion du premier matériau de scellement (celui de la couche 104) afin de « ramollir » la couche 104, c'est-à-dire réduire la dureté de cette couche 104. Ainsi, la pression mécanique appliquée entre le substrat 100 et le substrat 102 pendant le scellement permet de légèrement déformer la couche 104 pour assurer au final un contact intime entre les 2 surfaces à coller tout en favorisant la réaction entre les constituants des premier et second matériaux de scellement responsables de l'adhésion entre les substrats 100 et 102. De plus, ce ramollissement permet de sceller des surfaces présentant une rugosité importante sans avoir à s'en préoccuper, c'est-à-dire sans qu'il soit nécessaire de réaliser par exemple une planarisation pour supprimer ces rugosités, ce qui n'est pas le cas lors de la mise en oeuvre d'une thermocompression standard.

Avantageusement, il sera possible de choisir les premier et second matériaux de scellement tels qu'ils aient une dureté différente, ce qui permet de déformer le matériau de scellement comportant la phase la moins dure pour épouser la surface de la phase la plus dure de l'autre matériau de scellement.

De plus, la mise en contact des substrats 100, 102 par l'intermédiaire des couches de matériaux de scellement 104 et 108 se fera sous vide pour éviter de piéger des gaz lors du processus de scellement.

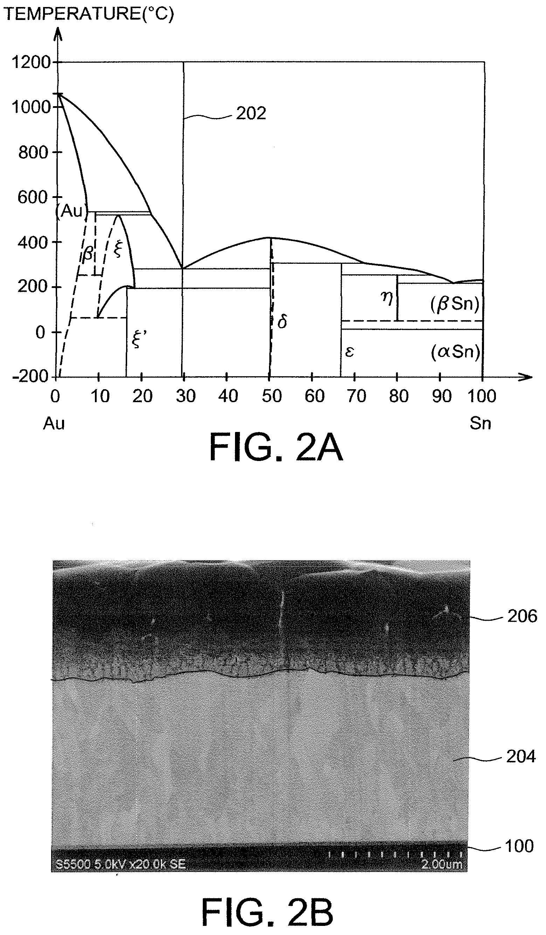

On décrit maintenant en liaison avec les figures 2A à 2D un exemple particulier de mise en oeuvre du procédé de scellement précédemment décrit.

Dans cet exemple de réalisation, le premier matériau de scellement de la couche 104 est un alliage eutectique de type AuSn. Le diagramme de phases d'un tel alliage est représenté sur la figure 2A. Dans le présent exemple de réalisation, l'alliage du premier matériau de scellement sera formé d'environ 29 % atomique d'étain et le reste d'or.

La droite verticale 202 représentée sur le diagramme de phases correspond à l'alliage eutectique utilisé ici. Il ressort de ce diagramme de phases que l'alliage eutectique considéré ici est composé, à température ambiante, des phases Au₅Sn (ξ') et AuSn (δ), la température de fusion étant égale à environ 278°C.

Cet alliage eutectique, destiné à former le premier matériau de scellement, est obtenu en réalisant tout d'abord un premier dépôt d'or, formant une première couche 204 sur le premier substrat 100, puis un second dépôt d'étain, formant une seconde couche 206, par électrolyse, par exemple à travers un masque dont le motif correspond à des cordons, directement sur le premier substrat 100 dans les proportions souhaitées (29% de Sn et 71% d'Au). Contrairement à l'exemple de la figure 1A, aucune phase n'est interposée entre la couche à base du premier matériau de scellement et le premier substrat 100 (voir figure 2B).

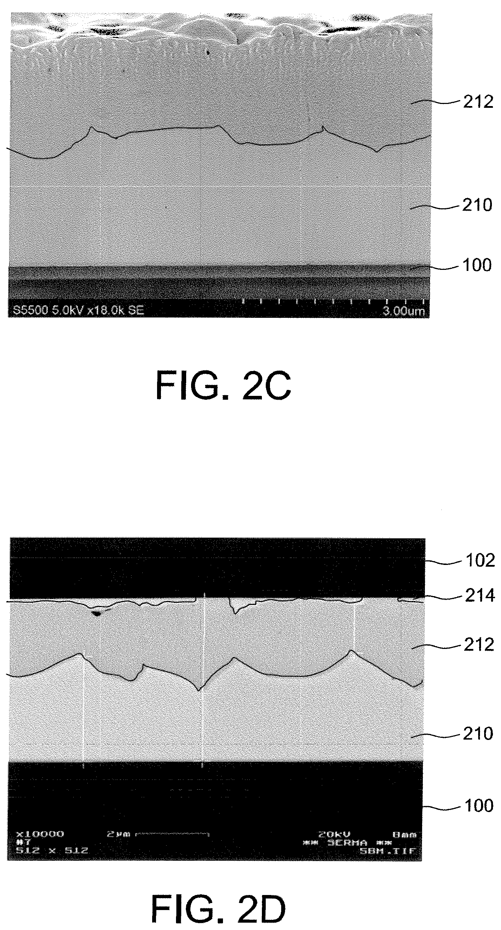

On réalise ensuite un traitement thermique, par exemple à une température sensiblement égale à 200°C et pendant une durée d'environ 4 heures, afin d'homogénéiser les dépôts 204 et 206 précédemment réalisés. Comme représenté sur la figure 2C, on obtient, sur le substrat 100, une couche 210 composée de la phase ξ disposée contre le substrat 100 et une couche 212 composée des phases AuSn (δ) + Au₅Sn (') en surface de la couche 210. Les couches 210, 212 ont ici une épaisseur égale à environ 4,5 µm et présentent par exemple une rugosité comprise entre environ 70 nm et 100 nm mesurée en AFM 5x5 µm². La couche 212 forme donc ici le premier matériau de scellement.

Parallèlement à la préparation du premier substrat 100, une couche à base d'or d'épaisseur égale à environ 100 nm, correspondant à la couche 108 à base du second matériau de scellement, représentée sur la figure 1A, est déposée sur le second substrat 102.

Cette couche d'or présente ici une rugosité égale à environ 1,5 nm mesurée en AFM 5x5 µm².

On procède ensuite à la thermocompression des deux substrats 100 et 102 par l'intermédiaire des couches de matériaux de scellement. Dans cet exemple de réalisation particulier, la température de scellement est choisie proche de la température de fusion de l'alliage eutectique formant la couche 212 (279°C), et par exemple égale à environ 270°C. Une pression égale à environ 50 bars est appliquée entre les deux substrats 100 et 102 (pression obtenue sur la surface effectivement collée), et cela pendant une durée égale à environ 20 mn à partir du moment où la température à atteint 270°C.

Le scellement entre les substrats 100 et 102 se produit suite à la réaction de l'or (second matériau de scellement) avec la couche AuSn (δ) + Au₅Sn (ξ' 212, qui forme la phase ξ ou Au₅Sn, référencée 214 sur la figure 2D et correspondant à la phase 110 représentée sur la figure 1C. Cette réaction est favorisée par une grande surface de contact entre les matériaux de scellement grâce au ramollissement de la phase 212.

Bien que dans cet exemple de réalisation la couche d'or servant de second matériau de scellement ait été choisie relativement fine (épaisseur égale à environ 100 nm), il est également possible que cette couche ait une épaisseur de l'ordre de 1 ou plusieurs micromètres. Le choix des épaisseurs des matériaux de scellement dépendra de l'espacement souhaité entre les substrats à assembler, tout en étant suffisante pour qu'une interdiffusion se produise au cours du scellement entre les constituants des phases des matériaux de scellement.

## Revendications

1. Procédé de scellement entre au moins deux éléments (100, 102), comportant au moins les étapes de :
- réalisation d'au moins un premier matériau de scellement (104, 212) sur au moins une face d'un premier (100) desdits deux élément,
- réalisation d'au moins un second matériau de scellement (108), différent du premier matériau de scellement (104, 212), sur au moins une face d'un second (102) desdits deux éléments,
- solidarisation desdits deux éléments (100, 102) par thermocompression des matériaux de scellement (104, 108, 212) l'un contre l'autre à une température Tc inférieure aux températures de fusion des premier et second matériaux de scellement (104, 108, 212),
dans lequel les premier et second matériaux de scellement (104, 108, 212) sont choisis tels qu'ils comportent chacun au moins une phase apte à réagir avec la phase de l'autre matériau de scellement par interdiffusion des constituants des phases des matériaux de scellement (104, 108, 212) lors de l'étapes de solidarisation, et tels que lors de l'étape de solidarisation, les phases des matériaux de scellement (104, 108, 212) réagissent ensemble en formant au moins une autre phase (110, 214) solide dont la température de fusion est supérieure à la température Tc,
le procédé **caractérisé en ce que**
le premier et/ou le second matériau de scellement (212) est un alliage eutectique obtenu au moins par la mise en oeuvre de plusieurs dépôts successifs de matériaux (204, 206) destinés à former l'alliage eutectique, et d'au moins un traitement thermique desdits matériaux (204, 206) destinés à former l'alliage eutectique à une température inférieure aux températures de fusion respectives desdits matériaux (204, 206) destinés à former l'alliages eutectique, les étapes de dépôts successifs et de traitement thermique étant mises en oeuvre avant l'étape de solidarisation desdits deux éléments (100, 102) par thermocompression.

2. Procédé de scellement selon la revendication 1, dans lequel la température Tc est inférieure à environ 300°C.

3. Procédé de scellement selon l'une des revendications précédentes, dans lequel le premier matériau de scellement (212) est un alliage à base d'or et d'étain, le second matériau de scellement étant de l'or.

4. Procédé de scellement selon l'une des revendications précédentes, dans lequel étape de solidarisation est mise en oeuvre à une température supérieure à environ 200°C et/ou comporte une compression du premier matériau de scellement (104, 212) contre le second matériau de scellement (108) à une pression supérieure à environ 10⁶ Pa.

5. Procédé de scellement selon l'une des revendications précédentes, dans lequel l'épaisseur du premier (104, 212) et/ou du second matériaux de scellement (108) est comprise entre environ 100 nm et 50 µm.

6. Procédé de scellement selon l'une des revendications précédentes, dans lequel, au cours de la réalisation de l'un des deux matériaux de scellement (104, 108, 212) comprenant des phases AuSn et Au₅Sn, une phase ξ (106, 210), différente de la ou des phases du premier (104) et du second (108, 212) matériau de scellement, se forme sur la face de l'un des deux éléments (100) telle que ledit un des deux matériaux de scellement (104, 212) soit disposé sur ladite phase ξ (106, 210).

7. Procédé de scellement selon l'une des revendications précédentes, dans lequel le premier matériau de scellement (104, 212) a une dureté différentes de la dureté du second matériau de scellement (108).

8. Procédé de scellement selon l'une des revendications précédentes, dans lequel l'étape de solidarisation, est mise en oeuvre sous vide.

9. Procédé de scellement selon l'une des revendications précédentes, dans lequel chaque élément (100, 102) comporte un substrat.

10. Procédé de scellement selon l'une des revendications précédentes, dans lequel les matériaux de scellement (104, 103, 212) sont réalisés, sur les éléments (100, 102), sous forme de couches ou de cordons.

## Patentansprüche

1. Versiegelungsverfahren zwischen mindestens zwei Elementen (100, 102), umfassend mindestens die Schritte:
- Bereitstellen mindestens eines ersten Versiegelungsmaterials (104, 212) auf mindestens einer Oberfläche des ersten (100) der zwei Elemente,
- Bereitstellen mindestens eines zweiten Versiegelungsmaterials (108), das verschieden von dem ersten Versiegelungsmaterial (104, 212) ist, auf mindestens einer Oberfläche des zweiten (102) der zwei Elemente,
- Verbinden der zwei Elemente (100, 102) durch Thermokompression der Versiegelungsmaterialien (104, 108, 212), eines an das andere, bei einer Temperatur Tc, die unter den Schmelztemperaturen der ersten und zweiten Versiegelungsmaterialien (104, 108, 212) ist,
worin die ersten und zweiten Versiegelungsmaterialien (104, 108, 212) ausgewählt werden aus solchen, die jeweils mindestens eine Phase aufweisen, die geeignet ist, um mit der Phase des anderen Versiegelungsmaterials durch wechselseitige Diffusion der Bestandteile der Phasen des Versiegelungsmaterials (104, 108, 212) während des Verbindungsschritts zu reagieren, und so, dass während des Verbindungsschritts die Phasen der Versiegelungsmaterialien (104, 108, 212) miteinander reagieren unter Bildung mindestens einer anderen festen Phase (110, 214), deren Schmelztemperatur über der Temperatur Tc ist,
wobei das Verfahren **dadurch gekennzeichnet ist, dass** das erste und/oder zweite Versiegelungsmaterial (212) eine eutektische Legierung ist, erhalten durch zumindest Einsetzen von mehreren aufeinanderfolgenden Materialablagerungen (204, 206), die vorgesehen sind, um die eutektische Legierung zu bilden, und zumindest eine thermische Behandlung der Materialien (204, 206), die vorgesehen sind, um die eutektische Legierung zu bilden, bei einer Temperatur unter den jeweiligen Schmelztemperaturen der Materialien (204, 206), die vorgesehen sind, um die eutektische Legierung zu bilden, wobei die Schritte der aufeinanderfolgenden Ablagerung und der thermischen Behandlung durchgeführt werden vor dem Schritt der Verbindung der zwei Elemente (100, 102) durch Thermokompression.

2. Verfahren nach Anspruch 1, worin die Temperatur Tc unter etwa 300 °C ist.

3. Verfahren nach einem der vorhergehenden Ansprüche, worin das erste Versiegelungsmaterial (212) eine Legierung auf Basis von Gold und Zinn ist, das zweite Versiegelungsmaterial aus Gold ist.

4. Verfahren nach einem der vorhergehenden Ansprüche, worin der Schritt des Verbindens bei einer Temperatur über etwa 200 °C durchgeführt wird und/oder ein Pressen des ersten Versiegelungsmaterials (104, 212) gegen das zweite Versiegelungsmaterial (108) bei einem Druck über etwa 10⁶ Pa umfasst.

5. Verfahren nach einem der vorhergehenden Ansprüche, worin die Dicke der ersten (104, 212) und/oder der zweiten Versiegelungsmaterialien (108) zwischen etwa 100 nm und 50 µm umfasst.

6. Verfahren nach einem der vorhergehenden Ansprüche, worin sich während der Bereitstellung des einen der zwei Versiegelungsmaterialien (104, 108, 212), umfassend AuSn- und Au₅Sn-Phasen, eine Phase ξ (106, 210), verschieden von der oder den Phase(n) des ersten (104) und des zweiten (108, 212) Versiegelungsmaterials, auf der Oberfläche des einen der zwei Elemente (100) bildet, sodass das eine der zwei Versiegelungsmaterialien (104, 212) auf der Phase ξ (106, 210) abgeschieden wird.

7. Verfahren nach einem der vorhergehenden Ansprüche, worin das erste Versiegelungsmaterial (104, 212) eine Härte hat, die verschieden von der Härte des zweiten Versiegelungsmaterials (108) ist.

8. Verfahren nach einem der vorhergehenden Ansprüche, worin der Verfestigungsschritt unter Vakuum erfolgt.

9. Verfahren nach einem der vorhergehenden Ansprüche, worin jedes Element (100, 102) ein Substrat umfasst.

10. Verfahren nach einem der vorhergehenden Ansprüche, worin die Versiegelungsmaterialien (104, 108, 212) auf den Elementen (100, 102) in der Form von Schichten oder Strängen bereitgestellt werden.

## Claims

1. Sealing method between at least two elements (100, 102), comprising the following steps:
producing at least one first sealing material (104, 212) on at least one face of a first element (100) of said two elements;
producing at least one second sealing material (108), different from the first sealing material (104, 212), on at least one face of a second element (102) of said two elements;
securing said two elements (100, 102) together by thermocompression of the sealing materials (104, 108, 212) against each other at a temperature Tc below melting temperatures of the first and second sealing materials (104, 108, 212),
wherein the first and second sealing materials (104, 108, 212) are chosen such that they each have at least one phase able to react with the phase of the other sealing material by interdiffusion of components of the respective phases of the sealing materials (104, 108, 212) during the securing step, and such that during the securing step, the respective phases of the sealing materials (104, 108, 212) react together and form at least one another solid phase (110, 214) having a melting temperature that is higher than the temperature Tc,
the method being **characterized in that** the first and/or second sealing material (212) is an eutectic alloy obtained at least by implementing several successive depositions of materials (204, 206) intended to form the eutectic alloy, and at least one thermal treatment of said materials (204, 206) intended to form the eutectic alloy at a temperature below the respective melting temperatures of said materials (204, 206) intended to form the eutectic alloy, said successive depositions and thermal treatment being implemented before the securing of said two elements (100, 102) by thermocompression.

2. Sealing method according to claim 1, wherein the temperature Tc is less than about 300° C.

3. Sealing method according to one of the preceding claims, wherein the first sealing material (212) is a gold- and tin-based alloy, the second sealing material being gold.

4. Sealing method according to one of the preceding claims, wherein the securing step is carried out at a temperature greater than about 200° C and/or includes a compression of the first sealing material (104, 212) against the second sealing material (108) at a pressure greater than about 10⁶ Pa.

5. Sealing method according to one of the preceding claims, wherein the thickness of the first (104, 212) and/or second sealing material (108) is between about 100 nm and 50 µm.

6. Sealing method according to one of the preceding claims, wherein, during the production of one of the two sealing materials (104, 108, 212) comprising phases AuSn and Au₅Sn, a phase ξ (106, 210), different from the phase (s) of the first (104) and second (108, 212) sealing material, is formed on the face of one of the two elements (100) such that said one of the two sealing materials (104, 212) is arranged on said phase ξ (106, 210).

7. Sealing method according to one of the preceding claims, wherein the first sealing material (104, 212) has a different hardness from the hardness of the second sealing material (108).

8. Sealing method according to one of the preceding claims, wherein the securing step is carried out in a vacuum.

9. Sealing method according to one of the preceding claims, wherein each element (100, 102) includes a substrate.

10. Sealing method according to one of the preceding claims, wherein the sealing materials (104, 108, 212) are produced, on the elements (100, 102), in the form of layers or cords.
